# EUROPEAN PATENT APPLICATION

(11) **EP 2 975 420 A1**
(43) Date of publication of application: **20.01.2016**
(21) Application number: 14275153.6
(22) Date of filing: 18.07.2014
(51) Int. Cl.: G01R 31/333

(54) **Synthetic test circuit**

(71) Applicant: ALSTOM Technology Ltd, 5400 Baden (CH)
(72) Inventor: TRAINER, David Reginald, Alvaston, Derby DE24 0AQ (GB); PICKEN, Donald, Stafford, Staffordshire ST17 9BG (GB); DANG, Si, Stafford, Staffordshire ST16 2EB (GB); OATES, Colin Donald Murray, Stafford, Staffordshire ST17 0TL (GB)
(74) Representative: Potter Clarkson LLP

(57) **Abstract**

A synthetic test circuit (30), for performing an electrical test on a device (52) under test, comprises:
a terminal connectable to the device (52) under test;
a current injection circuit (36) operably connected to the terminal, the current injection circuit (36) including a current source (42), the current source (42) including a chain-link converter, the chain-link converter including a plurality of modules, each module including at least one energy storage device; and
a controller (50) configured to operate each module to selectively bypass the or each corresponding energy storage device and insert the or each corresponding energy storage device into the chain-link converter so as to generate a voltage across the chain-link converter and thereby operate the current injection circuit (36) to inject a current waveform (I) into the device (52) under test.

## Description

This invention relates to a synthetic test circuit for performing an electrical test on a device under test, in particular a synthetic test circuit for performing an electrical test on a thyristor valve for use in high voltage direct current (HVDC) power transmission.

It is known to employ a synthetic test circuit to test a thyristor valve that is for use in HVDC power transmission. The term "synthetic" is used to describe the test circuit because the test circuit does not form part of an actual HVDC station converter, i.e. the thyristor valve under test is not connected into the actual HVDC station converter which transfers significant real power.

According to an aspect of the invention, there is provided a synthetic test circuit, for performing an electrical test on a device under test, comprising:
a terminal connectable to the device under test;
a current injection circuit operably connected to the terminal, the current injection circuit including a current source, the current source including a chain-link converter, the chain-link converter including a plurality of modules, each module including at least one energy storage device; and
a controller configured to operate each module to selectively bypass the or each corresponding energy storage device and insert the or each corresponding energy storage device into the chain-link converter so as to generate a voltage across the chain-link converter and thereby operate the current injection circuit to inject a current waveform into the device under test.

The structure of the chain-link converter (which may, for example, comprise a plurality of series-connected modules) permits build-up of a combined voltage across the chain-link converter, which is higher than the voltage available from each of its individual modules, via the insertion of the energy storage devices of multiple modules, each providing its own voltage, into the chain-link converter. In this manner the chain-link converter is capable of providing a stepped variable voltage source, which permits the generation of a voltage waveform across the chain-link converter using a step-wise approximation. As such the chain-link converter is capable of providing complex voltage waveforms to enable the current injection circuit to inject a wide range of current waveforms into the device under test, and so enables the synthetic test circuit to readily and reliably create test current conditions that are identical or closely similar to actual in-service current conditions.

In addition the capability of the chain-link converter to generate a voltage waveform thereacross using a step-wise approximation allows the current injection circuit to inject current waveforms of varying levels into the device under test, and thus renders the synthetic test circuit capable of electrically testing various devices across a wide range of device ratings.

Furthermore the modular arrangement of the chain-link converter means that the number of modules in the chain-link converter can be readily scaled up or down to modify the voltage capability of the chain-link converter to match the testing requirements of the device under test, without having to make significant changes to the overall design of the synthetic test circuit.

The provision of the chain-link converter in the current injection circuit therefore results in a synthetic test circuit that is not only capable of performing high quality electrical testing, but also has the flexibility to perform an electrical test on a broad range of devices with different device ratings.

In a preferred embodiment of the invention, the synthetic test circuit may further include a voltage injection circuit operably connected to the terminal, the voltage injection circuit including a voltage source, the voltage source including a chain-link converter, the chain-link converter including a plurality of modules, each module including at least one energy storage device. In such an embodiment, the controller may be configured to operate each module to selectively bypass the or each corresponding energy storage device and insert the or each corresponding energy storage device into the chain-link converter so as to generate a voltage across the chain-link converter and thereby operate the voltage injection circuit to inject a voltage waveform into the device under test.

In a similar fashion to that of the current injection circuit, the structure of the chain-link converter enables the voltage injection circuit to inject a wide range of voltage waveforms into the device under test, and so enables the synthetic test circuit to readily and reliably create test voltage conditions that are identical or closely similar to actual in-service voltage conditions.

In embodiments employing the use of a voltage injection circuit, the controller may be configured to operate each module to selectively bypass the or each corresponding energy storage device and insert the or each corresponding energy storage device into the chain-link converter so as to generate a voltage across the chain-link converter and thereby operate the voltage injection circuit to inject a current waveform into the device under test.

The controller may be configured to operate the voltage injection circuit to inject a current waveform into the device under test when the current injection circuit is injecting a current waveform into the device under test. This allows the voltage injection circuit to contribute to the overall current waveform injected into the device under test, without having to modify the contribution of the current injection circuit.

The controller may be configured to operate the voltage injection circuit to inject a current waveform into the device under test when the current injection circuit is undergoing disconnection from the device under test. This is useful when the disconnection of the current injection circuit from the device under test is relatively slow and there is a need to inject a current waveform into the device under test to ensure a desired rate of change of current in the device under test.

The voltage source may include an inductor connected to the chain-link converter. The current source may include an inductor connected to the chain-link converter.

The inclusion of the or each inductor in the voltage source and/or the current source provides a current control element for improving control over the injection of a current waveform into the device under test.

In further embodiments of the invention, the current injection circuit may include a plurality of parallel-connected current sources. The number of parallel-connected current sources in the current injection circuit may vary to adapt the current capability of the current injection circuit for compatibility with the current rating and test current conditions of the device under test.

In embodiments of the invention employing the use of a plurality of parallel-connected current sources, the controller may include a plurality of sub-controllers. Each sub-controller may be configured to operate the chain-link converter of a respective one of the plurality of parallel-connected current sources independently of the chain-link converter of each of the other current sources. Independent control of the plurality of chain-link converters provides a reliable means of ensuring current sharing between the plurality of parallel-connected current sources to, for example, prevent thermal overload in one or more of the plurality of parallel-connected current sources.

In further embodiments of the invention employing the use of a plurality of parallel-connected current sources, when each current source includes an inductor connected to the corresponding chain-link converter, each inductor of each current source may be magnetically coupled with the inductor of at least one other of the current sources to regulate the current flowing in each inductor. Magnetically coupling the plurality of inductors in this manner provides another reliable means of ensuring current sharing between the plurality of parallel-connected current sources.

The plurality of inductors may be magnetically coupled with each other by way of the current source including a plurality of windings, the plurality of windings being electrically interconnected to allow a common current to flow in the plurality of windings, and each of the plurality of windings being mutually coupled with the inductor of a respective one of the current sources.

The synthetic test circuit may be rated for performing an electrical test on a switching element. The switching element is preferably a thyristor valve and further preferably a thyristor valve for use in high voltage direct current (HVDC) power transmission.

In order to be certified for service operation, a switching element must comply with various testing requirements.

The controller may be configured to operate the current injection circuit to inject a current waveform into the switching element to carry out an electrical test selected from a group including:
- application of a turn-on or turn-off rate of change of current to the switching element;
- application of a steady-state current to the switching element.

The controller may be configured to operate the voltage injection circuit to inject a voltage waveform into the switching element to carry out an electrical test selected from a group including:
- application of a turn-off recovery voltage transient and/or overshoot to the switching element;
- application of a turn-on or turn-off rate of change of voltage to the switching element;
- application of an off-state voltage stress to the switching element;
- application of a turn-on voltage transient to the switching element.

When the controller is configured to operate the voltage injection circuit to inject a voltage waveform into the switching element to apply a turn-off recovery voltage transient to the switching element, the controller may be configured to:
operate each module to selectively bypass the or each corresponding energy storage device and insert the or each corresponding energy storage device into the corresponding chain-link converter so as to generate a voltage across the corresponding chain-link converter to track a defined voltage profile and thereby apply the turn-off recovery voltage transient to the switching element; and/or
operate the voltage injection circuit to inject a current waveform with a defined rate of change of current into the switching element and thereby apply the turn-off recovery voltage transient to the switching element.

The structure of each module of the or each chain-link converter may vary to meet the testing requirements of the device under test.

Each energy storage device may be arranged in the respective module so as to be insertable in the or the respective chain-link converter to provide a bidirectional voltage source. This enables the or each chain-link converter to generate a bidirectional voltage waveform thereacross.

To provide a bidirectional voltage source, each module may include a plurality of module switches connected in parallel with an energy storage device in a full-bridge arrangement to define a bipolar module that can provide negative, zero or positive voltages.

To provide a bidirectional voltage source, each module may include a plurality of module switches connected in parallel with an energy storage device in a full-bridge arrangement to define:
a 4-quadrant bipolar module that can provide negative, zero or positive voltages and can conduct current in two directions; or
a 2-quadrant bipolar module that can provide negative, zero or positive voltages and can conduct current in only one direction.

Preferred embodiments of the invention will now be described, by way of non-limiting examples, with reference to the accompanying drawings in which:
Figure 1 shows schematically a synthetic test circuit according to a first embodiment of the invention;
Figure 2 shows schematically current and voltage injection circuits of the synthetic test circuit of Figure 1;
Figures 3 and 4 illustrate the basic operations of the current and voltage injection circuits of Figure 2;
Figure 5 illustrates actual in-service current and voltage conditions for a thyristor valve when it is used in a rectifier and an inverter;
Figure 6 illustrates the operation of the current injection circuit of Figure 2 to inject a current waveform into a thyristor valve under test;
Figure 7 illustrates the operation of the voltage injection circuit of Figure 2 to inject voltage and current waveforms into a thyristor valve under test;

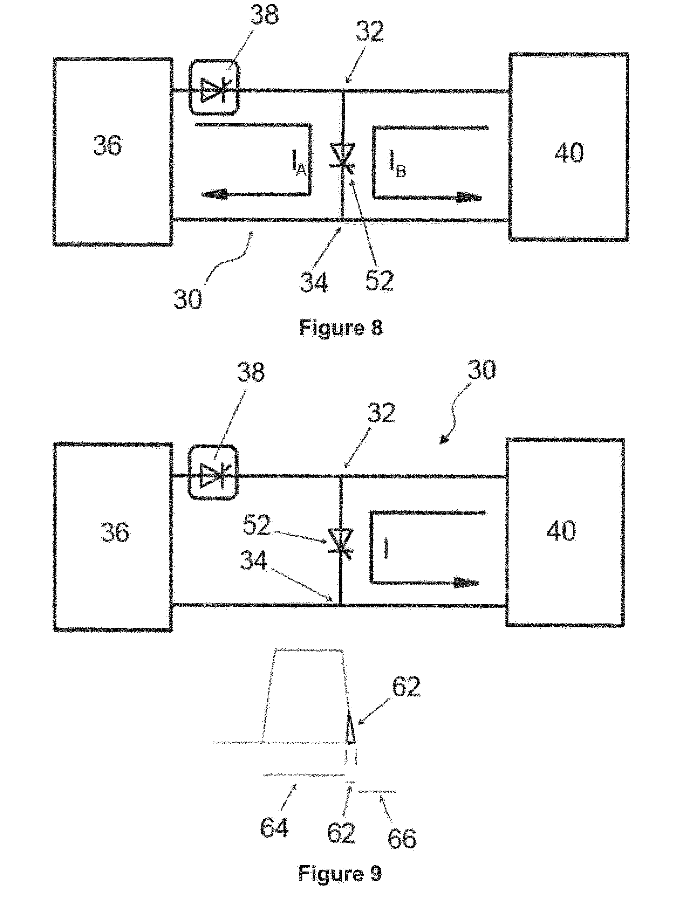

Figure 8 illustrates the operation of the current and voltage injection circuits of Figure 2 to simultaneously inject current waveforms into a thyristor valve under test;
Figure 9 illustrates the operation of the voltage injection circuit of Figure 2 to inject a current waveform into a thyristor valve under test;
Figure 10 illustrates the operation of the voltage injection circuit of Figure 2 to inject a voltage waveform into a thyristor valve under test to simulate an actual in-service voltage condition for a thyristor valve when it is used in an inverter;
Figure 11 shows schematically a current injection circuit of a synthetic test circuit according to a second embodiment of the invention; and
Figure 12 shows schematically a current injection circuit of a synthetic test circuit according to a third embodiment of the invention.

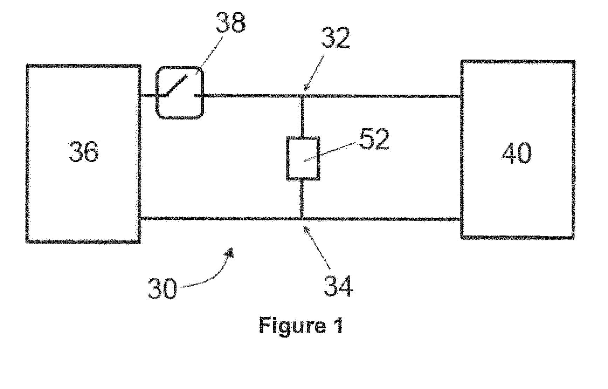

A synthetic test circuit according to a first embodiment of the invention is shown in Figure 1 and is designated generally by the reference numeral 30.

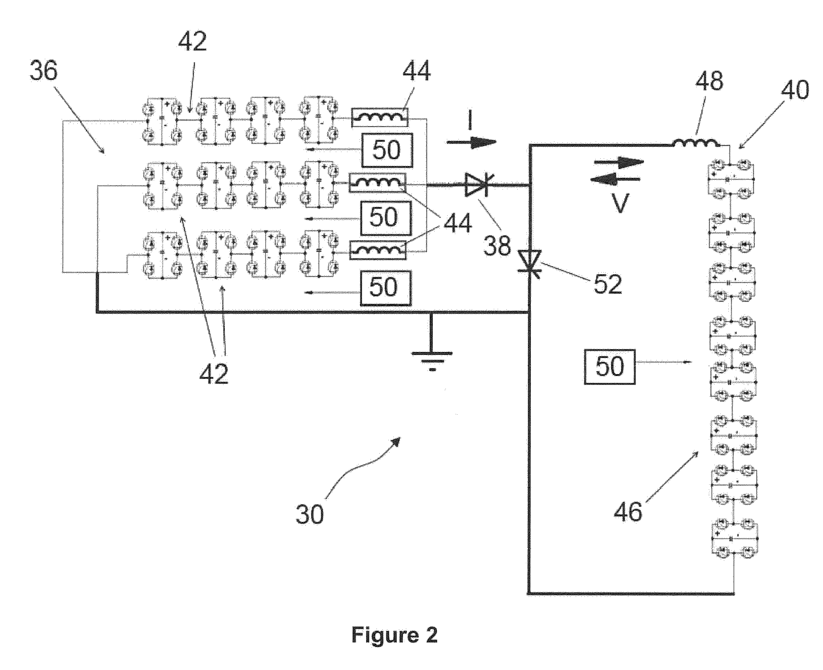

The synthetic test circuit 30 comprises first and second terminals 32,34, a current injection circuit 36, an isolation switch 38 and a voltage injection circuit 40. As shown in Figure 2, the current injection circuit 36 is connected in series with the isolation switch 38 between the first and second terminals 32,34, and the voltage injection circuit 40 is connected between the first and second terminals 32,34, and is thereby connected in parallel with the series connection of the current injection circuit 36 and isolation switch 38.

The current injection circuit 36 includes a plurality of parallel-connected current sources 42, each of which includes a series-connection of a chain-link converter and an inductor 44.

Each chain-link converter includes a plurality of series-connected modules. Each module includes two pairs of module switches and an energy storage device in the form of a capacitor. In each module, the pairs of module switches are connected in parallel with the capacitor in a full-bridge arrangement to define a 4-quadrant bipolar module that can provide negative, zero or positive voltages and can conduct current in two directions.

Each module switch constitutes an insulated gate bipolar transistor (IGBT) that is connected in anti-parallel with a diode. It is envisaged that, in other embodiments of the invention, each IGBT may be replaced by a gate turn-off thyristor, a field effect transistor, an injection-enhanced gate transistor, an integrated gate commutated thyristor or any other self-commutated switching device.

It is envisaged that, in other embodiments of the invention, each capacitor may be replaced by another type of energy storage device that is capable of storing and releasing energy, e.g. a battery or fuel cell.

The capacitor of each module is selectively bypassed or inserted into the respective chain-link converter by changing the states of the corresponding module switches. This selectively directs current through the capacitor or causes current to bypass the capacitor so that the module provides a negative, zero or positive voltage.

The capacitor of the module is bypassed when the module switches are configured to form a current path that causes current in the respective chain-link converter to bypass the capacitor, and so the module provides a zero voltage, i.e. the module is configured in a bypassed mode.

The capacitor of the module is inserted into the respective chain-link converter when the module switches are configured to allow the current in the respective chain-link converter to flow into and out of the capacitor. The capacitor then charges or discharges its stored energy so as to provide a non-zero voltage, i.e. the module is configured in a non-bypassed mode. The full-bridge arrangement of the module switches permits configuration of the module switches to cause current to flow into and out of the capacitor in either direction, and so each module can be configured to provide a negative or positive voltage in the non-bypassed mode.

The structure of each chain-link converter permits build-up of a combined voltage across each chain-link converter, which is higher than the voltage available from each of its individual modules, via the insertion of the capacitors of multiple modules, each providing its own voltage, into each chain-link converter. In this manner each chain-link converter is capable of providing a stepped variable voltage source, which permits the generation of a voltage waveform across each chain-link converter using a step-wise approximation. As such each chain-link converter is capable of providing complex voltage waveforms.

The voltage injection circuit 40 includes a voltage source 46. The voltage source 46 includes a chain-link converter, the structure and operation of which is identical to that of the chain-link converter of each current source 42 of the current injection circuit 36. The voltage source 46 converter further includes an inductor 48 connected in series with the chain-link converter.

It is envisaged that, in other embodiments of the invention, each of the current and voltage injection circuits may include a different number and/or arrangement of chain-link converters.

The controller 50 is configured to control switching of the module switches of each module to selectively bypass the corresponding capacitor and insert the corresponding capacitor into the corresponding chain-link converter so as to generate a voltage across the corresponding chain-link converter. In addition, with respect to the current injection circuit 36, the controller 50 includes a plurality of sub-controllers, each sub-controller being configured to operate the chain-link converter of a respective one of the plurality of parallel-connected current sources 42 independently of the chain-link converter of each of the other current sources 42.

The controller 50 is further configured to control switching of the isolation switch 38 to switch the current injection circuit 36 into and out of circuit with the first and second terminals 32,34 so as to selectively isolate the current injection circuit 36 from the device under test and the voltage injection circuit 40. The provision of the isolation switch 38 permits the current injection circuit 36 to be configured as a low voltage, high current injection circuit 36, and the voltage injection circuit 40 to be configured as a low current, high voltage injection circuit 40.

In use a device under test, namely a switching element in the form of a thyristor valve 52 that is for use in HVDC power transmission, is connected between the first and second terminals 32,34.

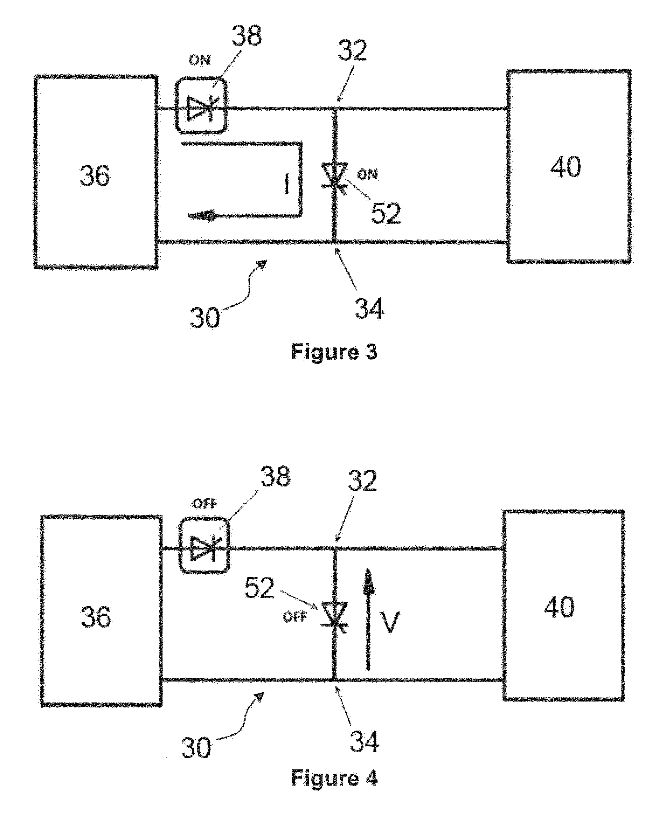

The configuration of the synthetic test circuit as set out above enables the current injection circuit 36 to be operated to inject a current waveform I into the thyristor valve 52 under test, as shown in Figure 3, and enables the voltage injection circuit 40 to be operated to inject a voltage waveform V into the thyristor valve 52 under test, as shown in Figure 4. A cycle of such injections of current and voltage waveforms may be repeated at a desired frequency (e.g. 50 Hz).

Preferably, the isolation switch 38 is closed when the current injection circuit 36 is operated to inject a current waveform I into the thyristor valve 52 under test, and the isolation switch 38 is opened when the voltage injection circuit 40 is operated to inject a voltage waveform V into the thyristor valve 52 under test. This means that the synthetic test circuit would not be required to supply high voltage and high current at the same time, thus minimising the amount of power used during electrical testing of the thyristor valve 52.

It will be appreciated that the number of parallel-connected current sources 42 in the current injection circuit 36 may vary to adapt the current capability of the current injection circuit 36 for compatibility with the current rating and test current conditions of the thyristor valve 52 under test. This is particularly useful due to the mismatch in current carrying capability between the IGBTs and the thyristor valve 52.

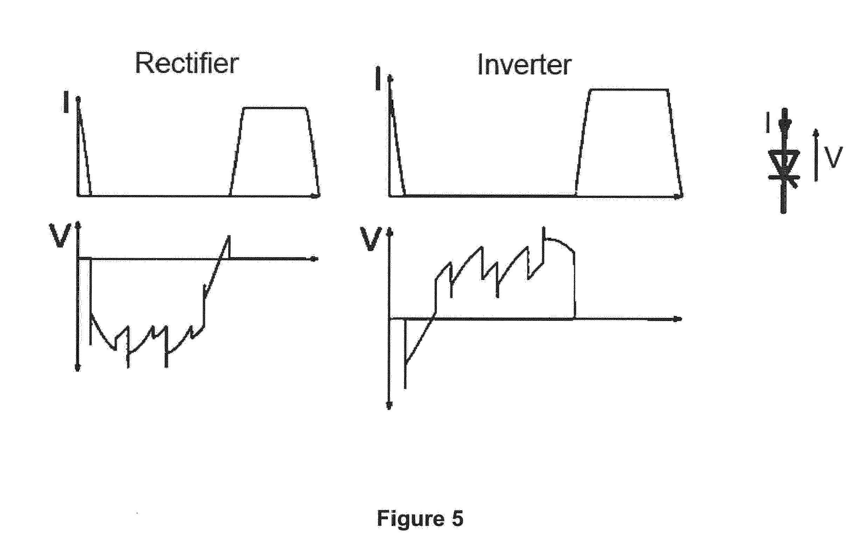

It can be seen from Figure 5 that the thyristor valve 52 experiences a complex, varying set of actual in-service current and voltage conditions during its use in a rectifier and an inverter.

The capability of the chain-link converter to provide complex voltage waveforms thereacross enables the current and voltage injection circuits 36,40 to inject a wide range of current and voltage waveforms into the device under test, and so enables the synthetic test circuit to readily and reliably create test current and voltage conditions that are identical or closely similar to the above actual in-service current and voltage conditions.

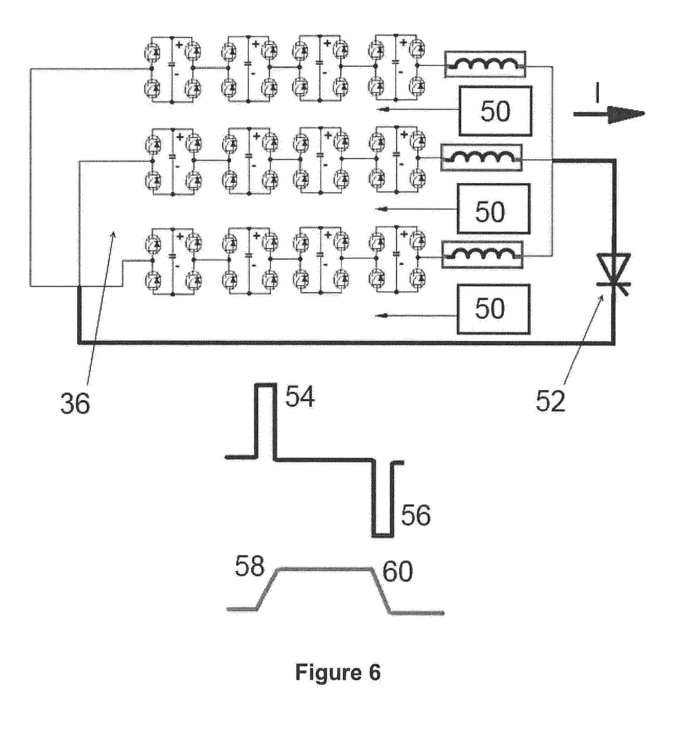

The actual in-service current conditions for the thyristor valve 52, as shown in Figure 5, includes a current waveform with positive and negative rates of change of current. As shown in Figure 6, the controller 50 is able to operate each module of the current injection circuit 36 to selectively bypass the corresponding capacitor and insert the corresponding capacitor into the corresponding chain-link converter so as to generate a positive voltage 54 across the corresponding chain-link converter and thereby operate the current injection circuit 36 to inject a current waveform with a positive rate of change of current 58 into the thyristor valve 52 under test, and to generate a negative voltage 56 across the corresponding chain-link converter and thereby operate the current injection circuit 36 to inject a current waveform with a negative rate of change of current 60 into the thyristor valve 52 under test, in order to create test current conditions that are identical or closely similar to the actual in-service current conditions.

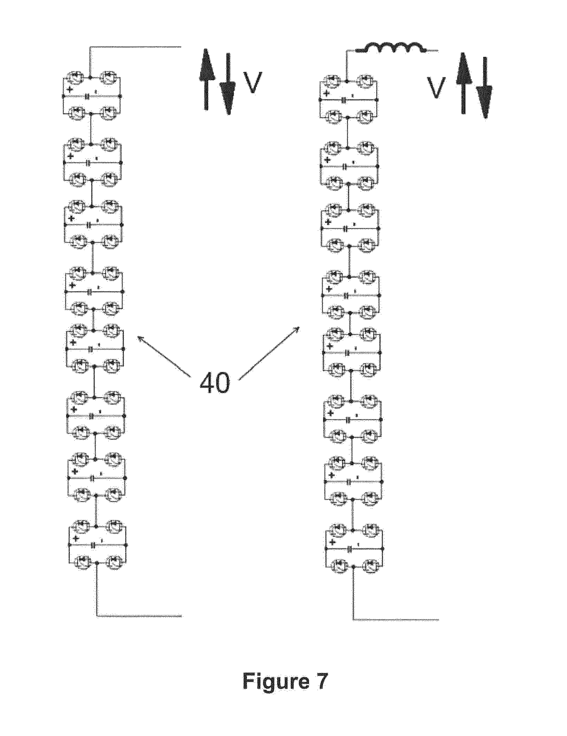

The actual in-service voltage conditions for the thyristor valve 52, as shown in Figure 5, includes a bidirectional voltage waveform. As shown in Figure 7, the controller 50 is able to operate each module of the voltage injection circuit 40 to selectively bypass the corresponding capacitor and insert the corresponding capacitor into the corresponding chain-link converter so as to generate a bidirectional voltage across the chain-link converter and thereby operate the voltage injection circuit 40 to inject a bidirectional voltage waveform V into the thyristor valve 52 under test, in order to create test voltage conditions that are identical or closely similar to the actual in-service voltage conditions..

In addition the controller 50 is able to operate each module of the voltage injection circuit 40 to selectively bypass the corresponding capacitor and insert the corresponding capacitor into the chain-link converter so as to generate a bidirectional voltage across the chain-link converter, thus modifying the voltage across the inductor, and thereby operate the voltage injection circuit 40 to inject a low-level current waveform into the thyristor valve 52 under test.

The controller 50 may operate the voltage injection circuit 40 to inject a current waveform I_{B} into the thyristor valve 52 under test when the current injection circuit 36 is injecting a current waveform I_{A} into the thyristor valve 52 under test. As mentioned earlier, this allows the voltage injection circuit 40 to contribute to the overall current waveform injected into the thyristor valve 52 under test, without having to modify the contribution of the current injection circuit 36.

The controller 50 may operate 62 the voltage injection circuit 40 to inject a current waveform into the thyristor valve 52 under test when the current injection circuit 36 is undergoing disconnection from the thyristor valve 52 under test, after the current injection circuit 36 being operated 64 to inject a current waveform into the thyristor valve 52 under test and prior to the voltage injection circuit 40 being operated 66 to inject a voltage waveform into the thyristor valve 52 under test. As mentioned earlier, this is useful when the disconnection of the current injection circuit 36 from the thyristor valve 52 under test is relatively slow (typically in the range of 300-400 µs) and there is a need to inject a current waveform into the thyristor valve 52 test under test to ensure a desired rate of change of current in the thyristor valve 52 under test at its turn-off. This ensures that the current injection circuit 36 is fully isolated before the voltage injection circuit 40 is operated to inject a voltage waveform into the thyristor valve 52 under test.

The controller 50 may operate the voltage injection circuit 40 to inject a current waveform into the thyristor valve 52 under test following the operation of the voltage injection circuit 40 to inject a voltage waveform into the thyristor valve 52 under test. This is useful when there is a need to inject a current waveform into the thyristor valve 52 test under test to ensure a desired rate of change of current in the thyristor valve 52 under test at its turn-on.

Typically a thyristor valve 52 that is for use in HVDC power transmission must comply with various testing requirements in order to be certified for service operation.

In order to check whether the thyristor valve 52 compiles with such testing requirements, the controller 50 is configured to operate the current injection circuit 36 to inject a current waveform into the thyristor valve 52 under test to carry out an electrical test selected from a group including:
- application of a turn-on or turn-off rate of change of current to the thyristor valve 52;
- application of a steady-state current to the thyristor valve 52.

In addition, in order to check whether the thyristor valve 52 compiles with such testing requirements, the controller 50 is configured to operate the voltage injection circuit 40 to inject a voltage waveform into the thyristor valve 52 under test to carry out an electrical test selected from a group including:
- application of a turn-off recovery voltage transient and/or overshoot to the thyristor valve 52;
- application of a turn-on or turn-off rate of change of voltage to the thyristor valve 52;
- application of an off-state voltage stress to the thyristor valve 52;
- application of a turn-on voltage transient to the thyristor valve 52.

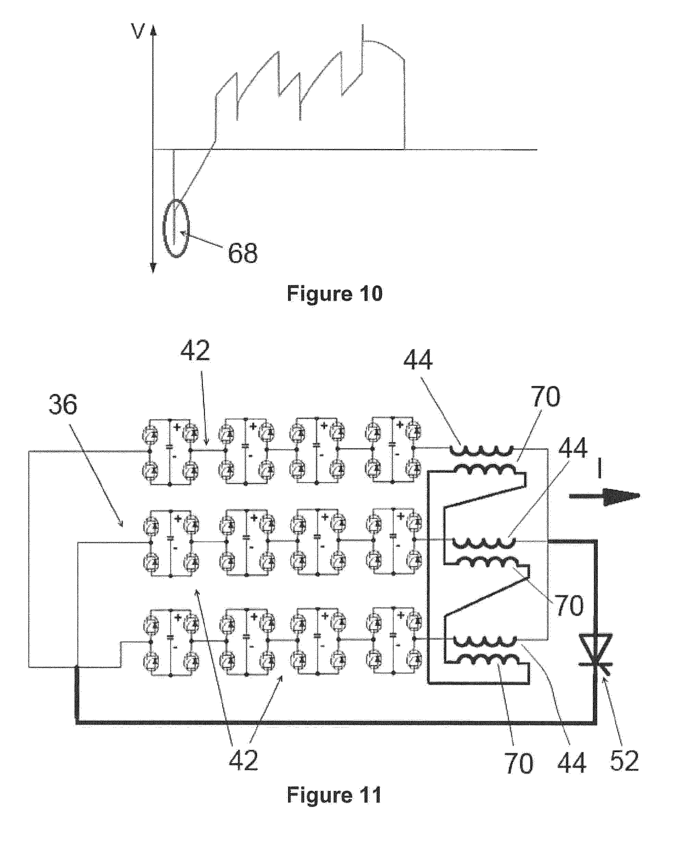

A thyristor valve 52 during its turn-off experiences a recovery voltage overshoot in the form of a negative voltage transient (as indicated by reference numeral 68 in Figure 10). Thus, in order to test the effect of this negative voltage transient on the thyristor valve 52, the controller 50 is configured to operate the voltage injection circuit 40 to inject a voltage waveform into the thyristor valve 52 under test to apply a turn-off recovery voltage transient to the thyristor valve 52 under test, and is configured to:
operate each module to selectively bypass the corresponding capacitor and insert the corresponding capacitor into the chain-link converter so as to modify a voltage across the chain-link converter to track a defined voltage profile corresponding to the actual in-service voltage conditions and thereby apply the turn-off recovery voltage transient to the thyristor valve 52 under test; and/or
operate the voltage injection circuit 40 to inject a current waveform with a defined rate of change of current into the thyristor valve 52 and thereby apply the turn-off recovery voltage transient to the thyristor valve 52 under test.

When the voltage injection circuit 40 is operated to inject a current waveform with a defined rate of change of current into the thyristor valve 52 and thereby apply the turn-off recovery voltage transient to the thyristor valve 52 under test, the turn-off recovery voltage transient is applied to the thyristor valve 52 under test by way of the voltage injection circuit 40 controlling the rate of change of current in the thyristor valve 52 under test and inductor 48.

In view of the foregoing the provision of the chain-link converters in the current and voltage injection circuits 36,40 therefore results in a synthetic test circuit that is not only capable of performing high quality electrical testing, but also has the flexibility to perform an electrical test on a broad range of thyristor valves 52 with different ratings. This is because the capability of the chain-link converter to generate a voltage waveform thereacross using a step-wise approximation allows the current and voltage injection circuits 36,40 to inject current and voltage waveforms of varying levels into the thyristor valve 52 under test, and thus renders the synthetic test circuit capable of electrically testing various thyristor valves 52 across a wide range of ratings.

In addition the modular arrangement of the chain-link converter means that the number of modules in the chain-link converter can be readily scaled up or down to modify the voltage capability of the chain-link converter to match the testing requirements of the thyristor valve 52 under test, without having to make significant changes to the overall design of the synthetic test circuit.

There is provided a synthetic test circuit according to a second embodiment of the invention, which is similar in structure and operation to the synthetic test circuit 30 of Figure 1, and like features share the same reference numerals.

The synthetic test circuit according to the second embodiment of the invention differs from the synthetic test circuit 30 of Figure 1 in that, in the synthetic test circuit according to the second embodiment of the invention, each inductor 44 of each current source 42 is magnetically coupled with the inductors 44 of the other current sources 42 to regulate the current flowing in each inductor 44. More specifically, as shown in Figure 11, the current injection circuit 36 includes a plurality of windings 70, the plurality of windings 70 are electrically interconnected to allow a common current to flow in the plurality of windings 70, and each of the plurality of windings 70 is mutually coupled with the inductor 44 of a respective one of the current sources 42.

The provision of the plurality of windings 70 sharing a common current and each winding 70 being mutually coupled with a respective one of the inductors 44 means that the magnetic flux in each mutually coupled inductor-winding pair is equal, and so each current flowing in each current source 42 is equal.

Magnetically coupling the plurality of inductors 44 in this manner therefore provides a reliable means of ensuring current sharing between the plurality of parallel-connected current sources 42 to, for example, prevent thermal overload in one or more of the current sources 42.

There is provided a synthetic test circuit according to a third embodiment of the invention, which is similar in structure and operation to the synthetic test circuit 30 of Figure 1, and like features share the same reference numerals.

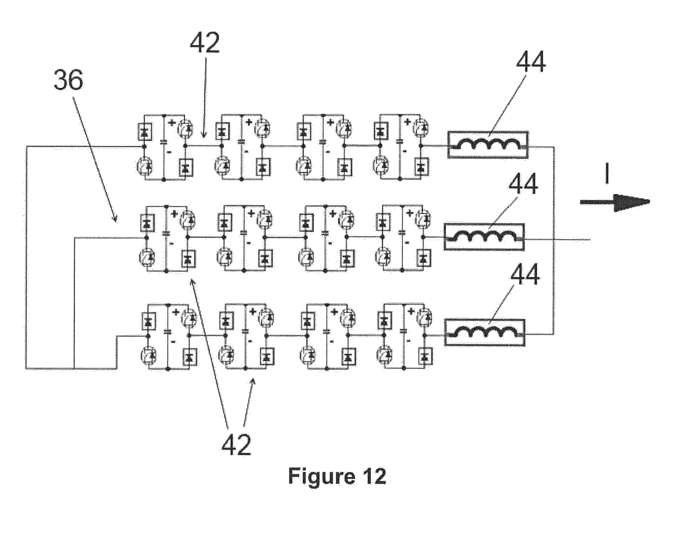

The synthetic test circuit according to the third embodiment of the invention differs from the synthetic test circuit 30 of Figure 1 in that, in the synthetic test circuit according to the third embodiment of the invention, each module of the current injection circuit 36 includes a plurality of module switches connected in parallel with the capacitor in a full-bridge arrangement to define a 2-quadrant bipolar module that can provide negative, zero or positive voltages and can conduct current in only one direction, as shown in Figure 12. More specifically, each module of the current injection circuit 36 has first and second sets of series-connected current flow control elements connected in parallel with the capacitor, each set of current flow control elements includes an active module switch to selectively direct current through the capacitor and a passive module switch in the form of a diode to limit current flow through the module to a single direction, and the current flow control elements and the capacitor in each module combine to selectively provide a voltage source 46.

The provision of such modules in the chain-link converters of the current sources 42 of the current injection circuit 36 results in reductions in the overall size, cost and weight of the synthetic test circuit due to the reduced number of active module switches and associated control hardware, without impacting on the ability of the current injection circuit 36 to inject a desired current waveform I into the thyristor valve 52 under test.

## Claims

1. A synthetic test circuit, for performing an electrical test on a device under test, comprising:
a terminal connectable to the device under test;
a current injection circuit operably connected to the terminal, the current injection circuit including a current source, the current source including a chain-link converter, the chain-link converter including a plurality of modules, each module including at least one energy storage device; and
a controller configured to operate each module to selectively bypass the or each corresponding energy storage device and insert the or each corresponding energy storage device into the chain-link converter so as to generate a voltage across the chain-link converter and thereby operate the current injection circuit to inject a current waveform into the device under test.

2. A synthetic test circuit according to any preceding claim further including a voltage injection circuit operably connected to the terminal, the voltage injection circuit including a voltage source, the voltage source including a chain-link converter, the chain-link converter including a plurality of modules, each module including at least one energy storage device,
wherein the controller is configured to operate each module to selectively bypass the or each corresponding energy storage device and insert the or each corresponding energy storage device into the chain-link converter so as to generate a voltage across the chain-link converter and thereby operate the voltage injection circuit to inject a voltage waveform into the device under test.

3. A synthetic test circuit according to Claim 2 wherein the controller is configured to operate each module to selectively bypass the or each corresponding energy storage device and insert the or each corresponding energy storage device into the chain-link converter so as to generate a voltage across the chain-link converter and thereby operate the voltage injection circuit to inject a current waveform into the device under test.

4. A synthetic test circuit according to Claim 3 wherein the controller is configured to operate the voltage injection circuit to inject a current waveform into the device under test when the current injection circuit is injecting a current waveform into the device under test and/or when the current injection circuit is undergoing disconnection from the device under test.

5. A synthetic test circuit according to any of Claims 2 to 4 wherein the voltage source includes an inductor connected to the chain-link converter.

6. A synthetic test circuit according to any preceding claim wherein the current source includes an inductor connected to the chain-link converter.

7. A synthetic test circuit according to any preceding claim wherein the current injection circuit includes a plurality of parallel-connected current sources.

8. A synthetic test circuit according to Claim 7 wherein the controller includes a plurality of sub-controllers, each sub-controller being configured to operate the chain-link converter of a respective one of the plurality of parallel-connected current sources independently of the chain-link converter of each of the other current sources.

9. A synthetic test circuit according to Claim 7 or Claim 8 when dependent from Claim 6 wherein each inductor of each current source is magnetically coupled with the inductor of at least one other of the current sources to regulate the current flowing in each inductor.

10. A synthetic test circuit according to Claim 9 wherein the current injection circuit includes a plurality of windings, the plurality of windings are electrically interconnected to allow a common current to flow in the plurality of windings, and each of the plurality of windings is mutually coupled with the inductor of a respective one of the current sources.

11. A synthetic test circuit according to any preceding claim wherein the synthetic test circuit is rated for performing an electrical test on a switching element, the switching element being preferably a thyristor valve and further preferably a thyristor valve for use in high voltage direct current (HVDC) power transmission.

12. A synthetic test circuit according to Claim 11 wherein the controller is configured to operate the current injection circuit to inject a current waveform into the switching element to carry out an electrical test selected from a group including:
• application of a turn-on or turn-off rate of change of current to the switching element;
• application of a steady-state current to the switching element.

13. A synthetic test circuit according to Claim 11 or Claim 12 when dependent from any of Claims 2 to 5 wherein the controller is configured to operate the voltage injection circuit to inject a voltage waveform into the switching element to carry out an electrical test selected from a group including:
• application of a turn-off recovery voltage transient and/or overshoot to the switching element;
• application of a turn-on or turn-off rate of change of voltage to the switching element;
• application of an off-state voltage stress to the switching element;
• application of a turn-on voltage transient to the switching element.

14. A synthetic test circuit according to Claim 13 wherein, when the controller is configured to operate the voltage injection circuit to inject a voltage waveform into the device under test to apply a turn-off recovery voltage transient to the switching element, the controller is configured to:
operate each module to selectively bypass the or each corresponding energy storage device and insert the or each corresponding energy storage device into the chain-link converter so as to generate a voltage across the chain-link converter to track a defined voltage profile and thereby apply the turn-off recovery voltage transient to the switching element; and/or
operate the voltage injection circuit to inject a current waveform with a defined rate of change of current into the switching element and thereby apply the turn-off recovery voltage transient to the switching element.

15. A synthetic test circuit according to any preceding claim wherein each energy storage device is arranged in the respective module so as to be insertable in the or the respective chain-link converter to provide a bidirectional voltage source.

16. A synthetic test circuit according to any preceding claim wherein each module includes a plurality of module switches connected in parallel with an energy storage device in a full-bridge arrangement to define a bipolar module that can provide negative, zero or positive voltages.

17. A synthetic test circuit according to Claim 16 wherein each module includes a plurality of module switches connected in parallel with an energy storage device in a full-bridge arrangement to define:
a 4-quadrant bipolar module that can provide negative, zero or positive voltages and can conduct current in two directions; or
a 2-quadrant bipolar module that can provide negative, zero or positive voltages and can conduct current in only one direction.
